## Europäisches Patentamt

## European Patent Office

## Office européen des brevets

(19)

(11) Numéro de publication: **0 203 836**
**B1**

(12)

# FASCICULE DE BREVET EUROPEEN

(45) Date de publication du fascicule du brevet:
16.08.89

(51) Int. Cl.⁴: **H01L 21/82**

(21) Numéro de dépôt: 86400869.3

(22) Date de dépôt: 22.04.86

(54) Procédé de fabrication de transistors à effet de champ, et transistors bipolaires latéraux sur un même substrat.

(30) Priorité: **26.04.85 FR 8506442**

(43) Date de publication de la demande:
**03.12.86 Bulletin 86/49**

(45) Mention de la délivrance du brevet:
**16.08.89 Bulletin 89/33**

(84) Etats contractants désignés:
**DE FR GB IT NL**

(56) Documents cités:
**EP-A- 0 080 523**
**EP-A- 0 139 266**
**FR-A- 2 002 925**
**GB-A- 2 143 082**
**US-A- 3 921 283**
**US-A- 3 999 213**

**IBM TECHNICAL DISCLOSURE BULLETIN,**
**vol. 23, no. 5, octobre 1980, pages 1917-1918, New York,**
**US; N.G. ANANTHA et al.: "High voltage power**
**transistor method"**

(73) Titulaire: **SGS-THOMSON MICROELECTRONICS S.A., 7,**
**Avenue Galliéni, F-94250 Gentilly(FR)**

(72) Inventeur: **Gris, Yvon, c/o Thomson-CSF**
**SCPI 19, avenue de Messine, F-75008 Paris(FR)**

(74) Mandataire: **Rinuy, Santarelli, 14, avenue de la Grande**
**Armée, F-75017 Paris(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

ACTORUM AG

## Description

L'invention concerne la fabrication des circuits intégrés.

Pour bénéficier simultanément de la rapidité de fonctionnement des transistors bipolaires, de la haute densité d'intégration des circuits à transistors à effet de champ, et de la faible consommation des circuits utilisant judicieusement des transistors à effet de champ complémentaires à canal N et à canal P, on cherche de plus en plus à réaliser des procédés technologiques de fabrication qui permettent de réaliser sur un même substrat de circuit intégré à la fois des transistors bipolaires et des transistors à effet de champ à canal N et à canal P.

Malheureusement, la technologie de fabrication de transistors à effet de champ est très différente de la technologie de fabrication des transistors bipolaires ; cela ne rend pas du tout impossible la juxtaposition de ces deux types de transistors sur le même substrat, mais cela tend à augmenter considérablement le nombre d'étapes technologiques nécessaires à la fabrication de ces circuits mixtes : si on part d'une technologie CMOS (transistors à effet de champ complémentaires), cette technologie ne permet pas de faire des transistors bipolaires. On intercale alors plusieurs étapes technologiques spécifiques à certains stades du processus de fabrication et cela permet de réaliser les circuits mixtes désirés.

Or les étapes de fabrication sont déjà nombreuses et chaque étape supplémentaire tend à réduire d'une part le rendement de fabrication et d'autre part la possibilité de conserver des règles de dessin topologiques correspondant à une haute densité d'intégration.

Enfin, certaines étapes spécifiques habituelles dans les technologies bipolaires (épitaxie N sur substrat P, formation de couches enterrées localisées) sont des étapes longues et délicates dont les technologies CMOS n'ont heureusement pas besoin et qu'on est pourtant obligé d'introduire lorsqu'on veut combiner technologies CMOS et bipolaires sur le même substrat.

On comprend par conséquent que ce problème d'intégration de deux technologies très différentes soit difficile à résoudre et que des circuits mixtes CMOS/bipolaires n'aient pu voir le jour que dans la mesure où la maitrise technologique permet quand-même de garder un rendement de fabrication acceptable malgré le grand nombre d'étapes de fabrication nécessaires.

A titre d'exemple, les technologies mixtes CMOS/bipolaire qui ont pu être proposées jusqu'à ce jour comportent au moins 12 niveaux de masquage différents dans leurs versions les plus simples.

On peut signaler comme art antérieur le brevet US-A 3 921 283 qui décrit un procédé de fabrication associant des transistors CMOS et bipolaires latéraux; par ailleurs le brevet EP-A O 080 523 mentionne l'utilisation de polysilicium commes source de dopage de collecteur et émetteur de transistor.

La présente invention propose une technologie mixte CMOS/bipolaire qui, dans sa version la plus simple, ne comporte que 9 niveaux de masquage et qui de plus n'utilise pas d'étape d'épitaxie et pas de formation de couche enterrée localisée.

Le procédé de fabrication selon l'invention comporte les étapes principales suivantes:

a) on part d'un substrat de silicium monocristallin (10) de type N dans lequel on forme des zones actives (A, B, C) séparées par de l'oxyde de silicium épais (24), avec, dans certaines des zones actives, des caissons (16, 18) de type P pour des transistors MOS à canal N et pour des transistors bipolaires NPN latéraux;

b) on forme dans les zones actives une couche isolante mince (26) servant d'oxyde de grille pour les transistors MOS;

c) on grave cet oxyde pour dénuder le silicium des zones actives dans des régions où seront formés les transistors bipolaires;

d) on dépose une couche de silicium polycristallin dopée avec une impureté de type N et susceptible de servir de source de diffusion de cette impureté vers le silicium monocristallin;

e) on grave la couche de silicium polycristallin pour définir un motif de grilles (30, 32) de transistors MOS, des contacts d'émetteur (34) et de collecteur (36) des transistors bipolaires, et des interconnexions (38);

f) on masque les transistors bipolaires et les transistors MOS à canal P et on implante une impureté de type N dans les régions de source et drain des transistor à canal N;

g) on forme des remblais isolants contre les bords latéraux des portions gravées de la couche de silicium et on dénude le silicium monocristallin à la surface des régions de drain et de source des transistor MOS et de la région de base des transistors bipolaires;

h) on masque les transistors à canal N et on implante une importées de type P dans les régions de source et drain des transistors à canal P et dans la région de base, entre les contacts d'émetteur de collecteur, des transistors bipolaires;

i) on dépose uniformément une couche métallique susceptible de former avec le silicium un siliciure conducteur là où elle vient en contact avec le silicium mais non là où elle vient en contact avec les remblais isolants et les murs d'isolation;

j) on forme par recuit un siliciure conducteur.

Les étapes suivantes du procédé sont classiques. Par ailleurs certaines étapes au début du procédé n'ont pas été indiquées car elles peuvent être traitées de plusieurs manières: implantations de couche anti-inversion de type P, implantation d'ajustement de seuil, recuits. Enfin, certaines étapes telles que l'implantation de type N et l'implantation de type P pourraient éventuellement être inversées.

La diffusion de l'impureté N du silicium polycristallin dans le silicium monocristallin se fait après l'étape f par soit un recuit spécifique soit le recuit classique des implantations ioniques de sources et drain.

Le transistor bipolaire réalisé est un transistor bipolaire latéral dans un caisson P.

D'autres caractéristiques et avantages de l'invention apparaîtront à la lecture de la description détaillée qui suit et qui est fait en référence aux dessins annéxés dans lesquels:

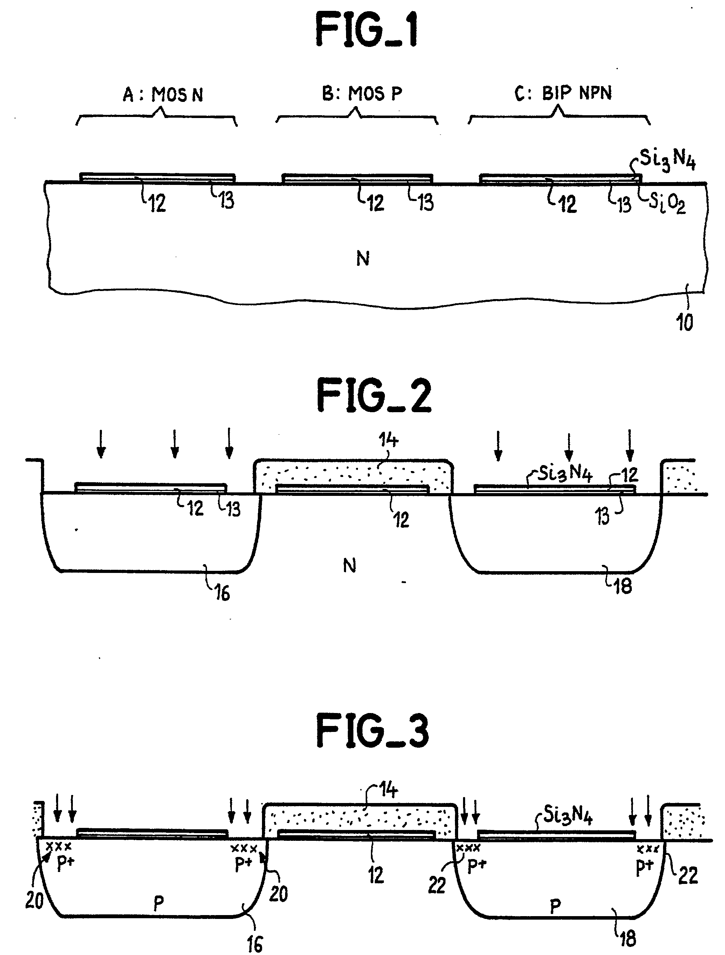

– les figures 1 à 12 représentent des étapes intermédiaires successives du procédé de fabrication selon l'invention.

On part d'un substrat semiconducteur de silicium 10 de type N dans lequel seront formés les composants actifs du circuit intégré.

La première étape consiste à déposer une couche de nitrure de silicium 12 sur un oxyde fin 13 et à la photograver selon un motif définissant les différentes zones actives du circuit (masque n°1).

Les zones actives sont celles sur lesquelles subsiste le nitrure ; elles seront séparées ultérieurement par l'oxyde épais localisé.

Sur la figure 1, on a délimité trois zones actives A, B, C, la première correspondant à la réalisation d'une transistor MOS à canal N, la deuxième correspondant à la réalisation d'un transistor MOS à canal P et la troisième correspondant à la réalisation d'un transistor bipolaire NPN.

La deuxième étape (figure 2) consiste à former des caissons de type P dans le substrat N. Pour cela on dépose une couche de résine 14 de masquage contre une implantation ionique à haute énergie. On photograve la résine pour la laisser subsister là où on ne doit pas former de caissons (masque n° 2). On effectue une implantation ionique à haute énergie (120 kev à 2 Mev) d'une impureté de type P, par exemple une implantation de bore à une dose de $2 \times 10^{11}$ at/cm², pour former un caisson 16 de type P englobant et entourant complètement la zone A (caisson pour le transistor MOS N) et un caisson 18 de type P englobant et entourant complètement la zone C (caisson pour le transistor bipolaire). L'implantation se fait à travers le nitrure 12 et l'oxyde 13. On notera que la résine 14 protège complètement et largement la zone active B, c'est-à-dire que la surface de masque délimitant la résine 14 au-dessus de la zone B est plus large de tous les côtés que la zone B.

L'étape suivante est une nouvelle implantation ionique (figure 3) d'une impureté de type P. Cette implantation se fait à travers le même masque n°2, c'est-à-dire pratiquement alors que le motif de résine 14 est encore en place. Mais c'est maintenant une implantation à faible énergie (30 kev) qui ne traverse pas le nitrure et qui se localise là où le substrat de silicium n'est protégé ni par le nitrure ni par la résine. On forme ainsi une zone superficielle annulaire 20 de type P⁺ tout autour de la région active A et une zone superficielle annulaire 22 tout autour de la région active C.

En variante, si l'implantation du caisson n'est pas faite à très forte énergie et nécessite un recuit avant l'implantation des régions 20 et 22, la résine 14 est enlevée avant la deuxième implantation, un recuit est effectué et une résine est remise en place selon le même motif (masque n° 2).

On élimine alors la résine 14, mais pas le nitrure 12. On effectue une oxydation épaisse du silicium, localisée par le nitrure qui empêche l'oxydation là où il est présent. On réalise ainsi une couche épaisse d'oxyde de silicium localisée tout autour des zones actives. Pendant cette oxydation, les impuretés de type P des régions 20 et 22 sont repoussées vers le bas par la croissance de l'oxyde ; les impuretés de type P se répartissent par diffusion dans le volume des caissons. Les régions 20 et 22 constituent alors des couches anti-inversion empêchant la formation de canaux conducteurs parasites entre zones actives adjacentes.

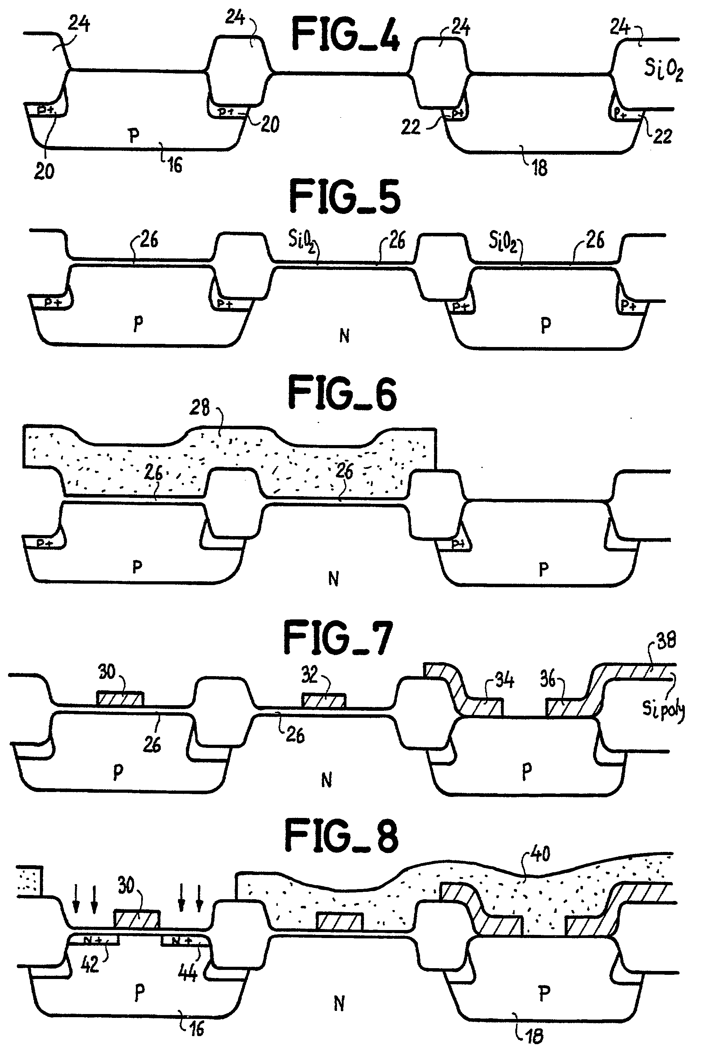

Après l'oxydation épaisse, on retire le nitrure (figure 4).

On effectue alors une oxydation superficielle de la surface dénudée de silicium des zones actives. Il en résulte une couche isolante mince 26 de quelques dizaines de nanomêtres (quelques centaines d'angströms) servant d'isolant de grille pour les transistors MOS (figure 5).

A cette étape on peut, si on le désire, faire une implantation d'impuretés non localisée, sur toute la surface des zones actives, pour l'ajustage des tensions de seuil des transistors MOS.

Ensuite, par une couche de résine photosensible 28 gravée selon un masque n°3, on masque la surface des zones actives A et B en découvrant la zone active C. On élimine alors l'oxyde de silicium mince 26 de la zone active C en conservant l'oxyde mince dans les zones A et B (figure 6).

Après retrait de la résine 28, on dépose uniformément une couche de silicium polycristallin fortement dopé de type N⁺ (dopage pendant le dépôt). Cette couche repose sur le silicium monocristallin dans la zone C, sur l'oxyde mince 26 dans les zones A et B, et enfin sur l'oxyde épais en dehors des zones actives. Cette couche est suffisamment dopée pour pouvoir elle-même servir de source de dopant lors d'une étape de recuit thermique, là où elle est en contact avec le silicium monocristallin. Par une étape de photogravure (masque n°4) on grave le silicium polycristallin selon un motif définissant les grilles 30 de transistors MOS à canal N, (zone A), les grilles 32 de transistors MOS à canal P (zone B) des contact d'émetteur et de collecteur 34 et 36 de transistors bipolaires (zone C), et des interconnexions 38 (principalement en dehors des zones actives) ; la figure 7 représente la structure de circuit intégré à ce stade de fabrication.

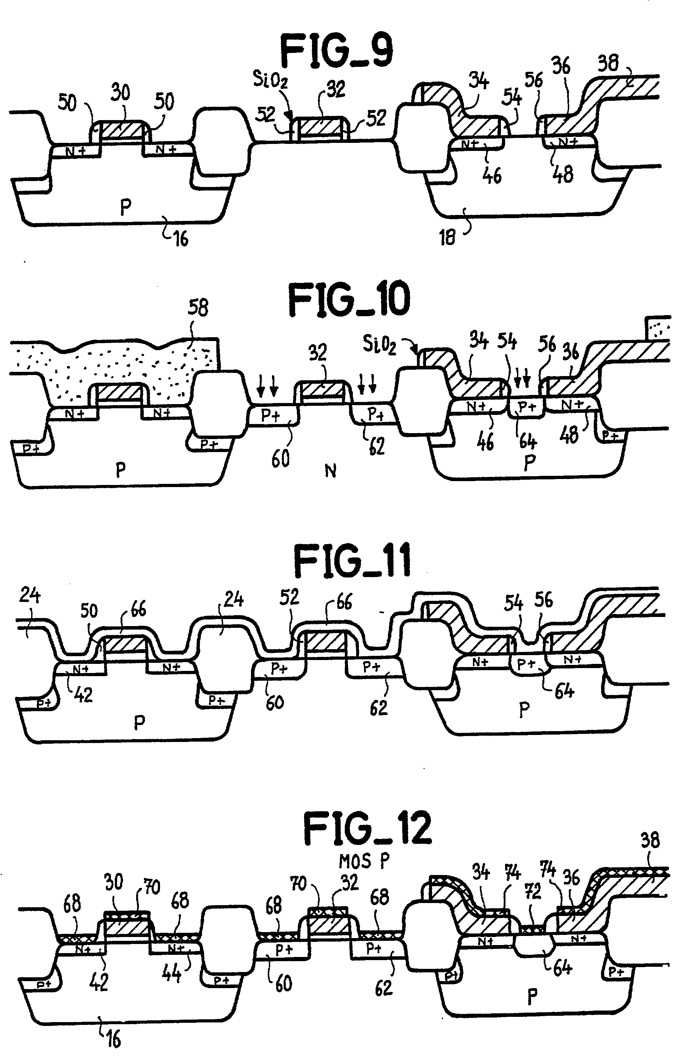

On dépose une couche de résine photosensible 40 susceptible de servir de masque d'implantation, et on la grave selon un motif (masque n°5) tel que la résine protège les zones actives B (MOS P) et C (bipolaires), et découvre les zones A (MOS N). On effectue une implantation d'impuretés de type N pour réaliser la source 42 et le drain 44 des transistors MOS à canal N. La résine 40 ainsi que la grille 30 masquent le substrat contre cette implantation et les régions de source et de drain sont ainsi autoalignées par rapport à la grille 30 (figure 8). L'implantation est de préférence une implantation d'arsenic à faible profondeur.

On élimine alors la résine 40. A ce stade, il serait possible de faire immédiatement une implantation des régions de source et de drain des transistors à canal P ainsi que de la base des transistors bipolaires en répétant un processus analogue à l'implantation de source et drain des transistors à canal N.

Ces deux implantations pourraient d'ailleurs être inversées.

On préfère cependant procéder à une formation de remblais isolants le long des bords verticaux des motifs de silicium polycristallin (figure 9). Le mode le plus simple consiste à recouvrir toute la surface de la structure d'une couche isolante à fort pouvoir couvrant, c'est-à-dire d'une couche qui vient s'appliquer aussi bien contre les surfaces horizontales que contre les sufaces verticales et qui épouse donc complètement le relief de la surface tel qu'on le voit sur les figures. L'épaisseur du dépôt est choisie égale à la largeur désirée pour les remblais isolants (à leur base). Cette épaisseur est sensiblement constante aussi bien dans le sens vertical sur les surfaces horizontales que dans le sens horizontal sur les surfaces verticales. La couche déposée est de préférence une couche d'oxyde de silicium déposée par décomposition chimique en phase gazeuse à basse pression. Ce dépôt est suivi d'un recuit qui d'une part améliore l'homogénéité du dépôt et d'autre part assure une diffusion des impuretés des contacts d'émetteur 34 et de collecteur 36 (silicium polycristallin fortement dopé de type N) vers le silicium monocristallin avec lequel ils sont en contact. On forme ainsi les régions d'émetteur 46 et de collecteur 48 des transistors bipolaires des zones C.

Puis, par une gravure anisotrope verticale (gravure ionique réactive), on attaque uniformément l'oxyde de silicium déposé, l'attaque se poursuivant sur une épaisseur sensiblement égale à celle qui a été déposée ; l'attaque est effectuée jusqu'à mise à nu du silicium monocristallin dans les régions de source et drain des transistors MOS et les régions de base des transistors bipolaires, et également jusqu'à mise à nu de la surface supérieure du silicium polycristallin partout où il est présent.

L'attaque verticale est interrompue immédiatement après cette mise à nu, de sorte qu'il subsiste des remblais isolants d'oxyde de silicium le long des bords verticaux de tous les motifs de silicium polycristallin, c'est-à-dire essentiellement des remblais 50 le long des grilles 30 (zones A), des remblais 52 le long des grilles 32 (zones B), des remblais 54 à la frontière entre l'émetteur et la base des transistors bipolaires et des remblais 56 à la frontière entre le collecteur et la base des transistors bipolaires (zone C).

On dépose alors une nouvelle résine 58 de masquage contre une implantation ionique et on la grave (masque n°6) pour dénuder les zones actives B et C en protégeant les zones actives A (figure 10).

On implante des impuretés de type P (bore) pour réaliser les régions de source 60 et drain 62 des transistors MOS à canal P, autoalignées par rapport à la grille 32 qui sert également de masque ; on réalise en même temps une implantation dans la portion de zone active C qui sépare le contact d'émetteur 34 du contact de collecteur 36 ou plus précisément qui sépare le remblai isolant 54 du remblai isolant 56 car ces remblais servent également de masque. Cette portion de zone active C implantée de bore constitue alors une région de base 64 pour le transistor bipolaire (NPN latéral). La largeur de base peut être réduite à environ 0,6 micromêtres (environ 1 à 1,2 micromêtres d'espacement entre les contacts d'émetteur et collecteur, diminué de la distance latérale de diffusion des régions N+ 46 et 48 à partir des bords du silicium polycristallin servant de source de dopant.

Après un recuit permettant notamment une légère diffusion latérale des impuretés de type P implantées dans l'étape précédente, on effectue éventuellement une désoxydation superficielle du substrat pour mettre à nu le silicium uniquement dans les régions de source, drain et base des transistors (régions actives non recouvertes de silicium polycristallin), ainsi que la surface du silicium polycristallin.

Puis on dépose une couche d'un métal susceptible de former un composé homogène conducteur (siliciure) ou un alliage conducteur avec le silicium, par exemple le platine, le tantale ou d'autres métaux. Ce métal va s'allier avec le silicium et doit pouvoir être éliminé sans problème là où il ne s'allie pas.

Comme on le voit sur la figure 11, la couche de métal 66 déposée uniformément vient en contact avec l'oxyde épais des murs isolants, avec les remblais isolants 50, 52, 54, 56, avec le silicium monocristallin des régions de source et de drain (42, 44, 60, 62) et de base (64), et enfin avec le silicium polycristallin des grilles (30, 32), des contacts d'émetteur et collecteur (34, 36) et des interconnexions (38).

Une manière commode de faire un siliciure consiste à utiliser du platine comme métal de la couche 66, et à recuire le substrat. Le siliciure de platine ne se forme que là où le platine est en contact direct avec le silicium monocristallin ou polycristallin. Après ce recuit on enlève à l'eau régale le platine qui ne s'est pas transformé en siliciure, c'est-à-dire celui qui reposait sur l'oxyde de silicium, et on aboutit à la structure de la figure 12 où les contacts de source et de drain 68 des transistors MOS à canal N et P sont en siliciure de platine et sont bien séparés des grilles 30 et 32, grilles qui sont elles-mêmes surmontées de siliciure de platine 70 plus conducteur que le silicium monocristallin. De même le contact de base 72 est en siliciure de platine bien séparé par les remblais isolants des contacts d'émetteur et de collecteur 34, 36 qui eux-mêmes sont recouverts (comme les interconnexions 38) de siliciure de platine 74 qui améliore leur conductivité.

Avec un dépôt de tantale au lieu de platine on pourrait procéder d'une manière différente pour aboutir à une structure analogue : par un recuit en atmosphère oxydant sèche à température modérée (environ 500°C) on peut transformer le tantale en siliciure de tantale là où il est en contact avec le silicium monocristallin ou polycristallin, et en oxyde de tantale (isolant) là où il est en contact avec l'oxyde de silicium. Il n'est pas nécessaire alors d'éliminer le tantale non transformé en siliciure.

Le procédé de fabrication se poursuit par des opérations classiques : dépôt d'oxyde épais, ouverture de contacts dans l'oxyde (masque n°7), dépôt d'aluminium, gravure d'un motif d'interconnexions en aluminium (masque n°8), dépôt d'une couche de passivation, gravure de cette couche pour ouvrir des plages de contact pour la soudure de fils d'accès (masque n°9).

## Revendications

1. Procédé de fabrication d'un circuit-intégré incorporant des transistors MOS à canal N et P et des transistors bipolaires, procédé comprenant les étapes principales suivantes:

a) on part d'un substrat de silicium monocristallin (10) de type N dans lequel on forme des zones actives (A, B, C) séparées par de l'oxyde de silicium épais (24), avec, dans certaines des zones actives, des caissons (16, 18) de type P pour des transistors MOS à canal N et pour des transistors bipolaires NPN latéraux;

b) on forme dans les zones actives une couche isolante mince (26) servant d'oxyde de grille pour les transistors MOS;

c) on grave cet oxyde pour dénuder le silicium des zones actives dans des régions où seront formés les transistors bipolaires;

d) on dépose une couche de silicium polycristallin dopée avec une impureté de type N et susceptible de servir de source de diffusion de cette impureté vers le silicium monocristallin;

e) on grave la couche de silicium polycristallin pour définir un motif de grilles (30, 32) de transistors MOS, des contacts d'émetteur (34) et de collecteur (36) des transistors bipolaires, et des interconnexions (38);

f) on masque les transistors bipolaires et les transistors MOS à canal P et on implante une impureté de type N dans les régions de source (42) et drain (44) des transistors à canal N;

g) on forme des remblais isolants (50, 52, 54, 56) contre les bords latéraux des portions gravées de la couche d silicium et on dénude le silicium monocristallin à la surface des régions de drain et de source des transistors MOS et de la région de base des transistors bipolaires;

h) on masque les transistors à canal N et on implante une impureté de type P dans les régions de source (60) et drain (62) des transistors à canal P et dans la région de base (64), entre les contacts d'émetteur (34) et de collecteur (36), des transistors bipolaires;

i) on dépose uniformément une couche métallique (66) susceptible de former avec le silicium un siliciure conducteur là où elle vient en contact avec le silicium mais non là où elle vient en contact avec les remblais isolants et les murs d'isolation;

j) on forme par recuit un siliciure conducteur.

2. Procédé de fabrication d'un circuit intégré selon la revendication 1, caractérisé en ce que le métal susceptible de former un siliciure est du platine et qu'il est prévu une étape d'enlèvement à l'eau régale du platine non transformé en siliciure.

3. Procédé de fabrication d'un circuit intégré selon la revendication 1, caractérisé en ce que le métal susceptible de former un siliciure est du tantale et qu'on effectue la transformation du métal en siliciure en atmosphère oxydante sèche à température modérée pour transformer en oxyde de tantale le tantale déposé sur de l'oxyde de silicium.

4. Procédé de fabrication d'un circuit intégré selon l'une quelconque des revendications 1 à 3, caractérisé en ce que la formation de remblais isolants est effectuée par dépôt uniforme couvrant d'oxyde de silicium, suivi d'une gravure anisotropique verticale.

5. Procédé selon la revendication 1, caractérisé en ce qu'on effectue un recuit après l'étape e pour faire diffuser l'impureté du silicium polycristallin dans le silicium monocristallin.

## Patentansprüche

1. Verfahren zur Herstellung einer integrierten Schaltung, die P- und N-Kanal-MOS-Transistoren sowie bipolare Transistoren umfaßt, dadurch gekennzeichnet, daß es folgende Hauptschritte umfaßt:

a) Es wird von einem monokristallinen Siliziumsubstrat (10) vom N-Typ ausgegangen, in welchem man aktive Zonen (A, B, C) bildet, die durch ein dickes Siliziumoxid (24) getrennt sind, wobei in bestimmten aktiven Zonen Wannen (16, 18) vom P-Typ für N-Kanal-MOS-Transistoren und für laterale, bipolare NPN-Transistoren gebildet werden,

b) auf den aktiven Zonen wird eine dünne Isolationsschicht (26) ausgebildet, die als Gate-Oxid für die MOS-Transistoren dient,

c) dieses Oxid wird geätzt, um das Silizium der aktiven Zonen in den Bereichen freizulegen, in denen die bipolaren Transistoren ausgebildet werden sollen,

d) es wird eine Schicht aus polykristallinen Silizium abgeschieden, die mit einer Verunreinigung vom N-Typ dotiert und in der Lage ist, als Diffusionsquelle für diese Verunreinigung zum monokristallinen Silizium hin zu dienen,

e) die Schicht aus polykristallinen Silizium wird geätzt, um ein Muster für die Gate-Elektroden (30, 32) der MOS-Transistoren sowie Emitter-Kontakte (34) und Kollektor-Kontakte (36) der bipolaren Transistoren und Zwischenverbindungen (38) zu schaffen,

f) die bipolaren Transistoren und die P-Kanal-MOS-Transistoren werden maskiert und es wird eine Verunreinigung vom N-Typ in die Quellenbereiche (42) und die Senkenbereiche (44) der N-Kanal-Transistoren implantiert,

g) an den Seitenrändern der geätzten Teile der Siliziumschicht werden Isolationswälle (50, 52, 54, 56) ausgebildet, und es wird das monokristalline Silizium an der Oberfläche der Senken- und Quellenbereiche der MOS-Transistoren und im Basisbereich der bipolaren Transistoren freigelegt,

h) die N-Kanal-Transistoren werden maskiert, und es wird eine Verunreinigung vom P-Typ in die Quellenbereiche (60) und die Senkenbereiche (62) der P-Kanal-Transistoren und in den Basisbereich (64) der bipolaren Transistoren zwischen den Ermitterkontakten (34) und den Kollektorkontakten (36) implantiert,

i) es wird eine metallische Schicht (66) gleichförmig abgeschieden, die in der Lage ist, dort ein Leiter-Silizid zu bilden, wo sie mit dem Silizium in Berührung kommt, jedoch nicht dort, wo sie mit den Isolationswällen und den Isolationsmauern in Berührung kommt,

j) es wird durch Glühen ein Leiter-Silizid gebildet.

2. Verfahren zur Herstellung einer integrierten Schaltung nach Anspruch 1, dadurch gekennzeichnet, daß das Metall, das in der Lage ist, ein Silizid zu bilden, Platin ist und daß ein Schritt zum Beseitigen des nicht in Silizid umgewandelten Platins durch Königswasser vorgesehen ist.

3. Verfahren zum Herstellen einer integrierten Schaltung nach Anspruch 1, dadurch gekennzeichnet, daß das Metall, das in der Lage ist, ein Silizid zu bilden, Tantal ist und daß man eine Umwandlung des Metalls in Silizid in einer oxidierenden trockenen Atmosphäre bei mäßiger Temperatur durchführt, im das auf dem Siliziumoxid abgeschiedene Tantal in Tantaloxid umzuwandeln.

4. Verfahren zur Herstellung einer integrierten Schaltung nach einem der Ansprüche 1 bis 3, dadurch gekennzeichnet, daß die Ausbildung der Isolationswälle durch die Abscheidung einer gleichförmigen Schicht aus Siliziumoxid bewirkt wird, worauf eine anisotrope vertikale Ätzung folgt.

5. Verfahren nach Anspruch 1, dadurch gekennzeichnet, daß man einen Glühvorgang nach dem Schritt e) durchführt, um zu bewirken, daß die Verunreinigung des polykristallinen Siliziums in das monokristalline Silizium hineindiffundiert.

## Claims

1. A method for producing an integrated circuit incorporating N- and P-channel MOS transistors and bipolar transistors comprising the following principal stages:

a) an N-type monocrystalline silicon substrate (10) is provided in which active zones (A, B, C) separated by thick regions of silicon oxide (24) are formed, having, in certain of the active zones, P-type wells (16, 18) for the N-channel MOS transistors and for the NPN bipolar lateral transistors;

b) a thin insulating layer (26) serving as oxide of the gate for the MOS transistors is formed in the active zones;

c) this oxide is etched to expose the silicon in the active zones in the regions where the bipolar transistors will be formed;

d) a layer of polycrystalline silicon, doped with an N-type impurity and able to act as a source for diffusion of this impurity towards the monocrystalline silicon, is deposited;

e) the layer of polycrystalline silicon is etched to define a pattern of gates (30, 32) of the MOS transistors, emitter contacts (34) and collector contacts (36) of the bipolar transistors and interconnections (38);

f) the bipolar transistors and the P-channel MOS transistors are masked and an N-type impurity is implanted into the source regions (42) and drain regions (44) of the N-channel transistors;

g) insulating bankings (50, 52, 54, 56) are formed against the lateral edges of the etched portions of the silicon layer, and the monocrystalline silicon is exposed at the surface of the drain and source regions of the MOS transistors and of the base region of the bipolar transistors;

h) the N-channel transistors are masked and a P-type impurity is implanted into the source regions (60) and drain regions (62) of the P-channel transistors and in the base region (64) between the emitter contacts (34) and the collector contacts (36) of the bipolar transistors;

i) a metallic layer (66) is uniformly deposited, capable of forming with the silicon a conductive silicide where it comes into contact with the silicon but not where it comes into contact with the insulating bankings and the insulating walls;

j) a conductive silicide is formed by annealing.

2. A method for producing an integrated circuit according to claim 1, characterized in that the metal capable of forming a silicide is platinum, and a stage is provided for removing with aqua regia the platinum not converted into silicide.

3. A method for producing an integrated circuit according to claim 1, characterized in that the metal capable of forming a silicide is tantalum, and the metal is converted into the silicide in a dry oxidizing atmosphere at a moderate temperature to convert the tantalum deposited on the silicon oxide into tantalum oxide.

4. A method for producing an integrated circuit according to any one of claims 1 to 3, characterized in that the formation of the insulating bankings is performed by depositing a uniform covering of silicon oxide followed by anisotropic vertical etching.

5. A method according to claim 1, characterized in that annealing is performed after stage e to diffuse the impurity in the polycrystalline silicon into the monocrystalline silicon.

# FIG_1

A: MOS N   B: MOS P   C: BIP NPN

$Si_3N_4$

12  13   12  13   12  13

$Si_iO_2$

N

10

# FIG_2

14

$Si_3N_4$   12

12  13   12   13

N

16   18

# FIG_3

14

$Si_3N_4$

P+   P+   12   P+   P+

20   20   22   22

P   P

16   18

EP 0 203 836 B1

FIG_4

FIG_5

FIG_6

FIG_7

FIG_8

EP 0 203 836 B1

FIG_9

FIG_10

FIG_11

FIG_12